# EUROPÄISCHE PATENTSCHRIFT

(11) **EP 2 057 681 B1**
(45) Veröffentlichungstag und Bekanntmachung des Hinweises auf die Patenterteilung: **07.11.2018**
(21) Anmeldenummer: 07817575.9
(22) Anmeldetag: 25.09.2007
(51) Int. Cl.: H01L 25/075, H01L 33/00, H01L 23/00, H01L 33/62, H01L 33/50

(54) **LEUCHTDIODENANORDNUNG UND VERFAHREN ZUR HERSTELLUNG EINER SOLCHEN**
LIGHT-EMITTING DIODE ARRANGEMENT AND METHOD FOR PRODUCING THE SAME
DISPOSITIF À DIODES LUMINEUSES ET SON PROCÉDÉ DE FABRICATION

(30) Priorität: 27.09.2006 DE 102006045691; 04.05.2007 DE 102007021009
(43) Veröffentlichungstag der Anmeldung: 13.05.2009
(73) Patentinhaber: OSRAM Opto Semiconductors GmbH, 93055 Regensburg (DE)
(72) Erfinder: SORG, Jörg Erich, 93053 Regensburg (DE); GRUBER, Stefan, 93077 Bad Abbach (DE); HERRMANN, Siegfried, 94362 Neukirchen (DE); HAHN, Berthold, 93155 Hemau (DE)
(74) Vertreter: Epping - Hermann - Fischer
(86) Internationale Anmeldenummer: PCT/DE2007/001733
(87) Internationale Veröffentlichungsnummer: WO 2008/040315

(56) Entgegenhaltungen:
- EP-A- 0 854 520
- EP-A- 1 667 228
- US-A1- 2005 023 550
- US-A1- 2006 154 393

## Beschreibung

Die Erfindung betrifft eine Leuchtdiodenanordnung und ein Verfahren zur Herstellung einer solchen.
Es sind Leuchtdiodenanordnungen bekannt, bei denen mehrere einzeln verkapselte LED-Bauelemente auf einem gemeinsamen Träger angeordnet sind. Solche Leuchtdiodenanordnungen haben für viele Anwendungen eine unzureichende Leuchtdichte und eine nicht hinreichend gleichmäßige Leuchtdichteverteilung.

US 2005/023550 offenbart eine Leuchtdiodenanordnung mit einer Mehrzahl von Halbleiterchips, die dazu vorgesehen sind, von ihrer Vorderseite elektromagnetische Strahlung zu emittieren und die mit ihrer der Vorderseite gegenüberliegenden Rückseite auf einer ersten Hauptfläche eines gemeinsamen Trägerkörpers befestigt sind, wobei die Halbleiterchips aus je einem substratlosen Halbleiterschichtstapel bestehen und ohne Hilfsträger an dem gemeinsamen Trägerkörper befestigt sind.

Bei anderen bekannten Leuchtdiodenanordnungen sind einzelne LED-Chips, die einen aktiven Halbleiterschichtstapel und ein Aufwachssubstrat und/oder einen Hilfsträger umfassen, auf einem gemeinsamen Träger angeordnet. Zwischen den einzelnen Halbleiterschichtstapeln verbleiben bei der Montage solcher LED-Chips Spalte. Die Spalte sind beispielsweise durch das Montageverfahren bedingt, etwa durch eine begrenzte Ablage-Genauigkeit und/oder einen Klebstoffrand seitlich vom Aufwachssubstrat und/oder Hilfsträger. Aktive Halbleiterschichtstapel, die auf einem Hilfsträger angeordnet sind, bedecken letzteren in der Regel nicht vollständig, wodurch die Größe der Spalte zwischen den aktiven Halbeiterschichtstapeln weiter erhöht ist. Die Spalte führen zu Bereichen verringerter Leuchtdichte in der Leuchtfläche der Leuchtdiodenanordnung und zu Ungleichmäßigkeiten in der Leuchtdichteverteilung.
Es ist daher eine Aufgabe der Erfindung, eine Leuchtdiodenanordnung anzugeben, die eine homogenere Leuchtdichte aufweist.

Diese Aufgabe wird durch eine Leuchtdiodenanordnung gemäß Patentanspruch 1 und durch ein Verfahren zur Herstellung einer Leuchtdiodenanordnung gemäß Patentanspruch 5 gelöst.

Merkmale von vorteilhaften Ausführungsformen und Weiterbildungen der Leuchtdiodenanordnung und des Verfahrens sind jeweils in den abhängigen Ansprüchen angegeben, deren Offenbarungsgehalt ausdrücklich in die Beschreibung aufgenommen wird.

Eine Leuchtdiodenanordnung gemäß der Erfindung umfasst eine Mehrzahl von Halbleiterchips, die dazu vorgesehen sind, von ihrer Vorderseite elektromagnetische Strahlung zu emittieren, und die mit ihrer der Vorderseite gegenüberliegenden Rückseite auf einer ersten Hauptfläche eines gemeinsamen Trägerkörpers befestigt sind, wobei die Halbleiterchips aus je einem substratlosen Halbleiterschichtstapel bestehen und ohne Hilfsträger an dem gemeinsamen Trägerkörper befestigt sind. Der Abstand zwischen der strahlungsemittierenden Vorderseite eines jeden Halbleiterschichtstapels und der ersten Hauptfläche des Trägerkörpers ist kleiner oder gleich 50 µm. Je zwei zueinander benachbarte Halbleiterschichtstapel haben in Draufsicht auf die erste Hauptfläche des Trägerkörpers gesehen einen Abstand von kleiner oder gleich 100 µm. Die Halbleiterschichtstapel sind in Reihe geschaltet, wobei entweder die Halbleiterschichtstapel je zwei elektrische Kontaktbereiche aufweisen, die zum elektrischen Anschließen des jeweiligen Halbleiterschichtstapels auf seiner Vorderseite angeordnet sind oder wobei die Halbleiterschichtstapel je einen elektrischen Kontaktbereich sowie eine Aussparung aufweisen, wobei der elektrische Kontaktbereich zum elektrischen Anschließen des Halbleiterschichtstapels an seiner Vorderseite angeordnet ist und wobei dann der Trägerkörper im Bereich der Aussparungen einen Anschlussbereich aufweist, der mit der Rückseite des Halbleiterschichtstapels elektrisch leitend verbunden ist.

Die im Folgenden jeweils für einen substratlosen Halbleiterschichtstapel offenbarten Ausführungsformen betreffen bevorzugt eine Mehrzahl, besonders bevorzugt alle, Halbleiterschichtstapel der Leuchtdiodenanordnung. Im Folgenden beziehen sich alle Erläuterungen des Aufbaus und der Herstellung der Leuchtdiodenanordnung auf deren Betrachtung in Draufsicht auf die erste Hauptfläche des Trägerkörpers und auf die Vorderseite des Halbleiterschichtstapels gesehen, wenn nichts anderes ausdrücklich angegeben oder offensichtlich ist.

Der Ausdruck "substratloser Halbleiterschichtstapel" bezeichnet im vorliegenden Zusammenhang einen Stapel von Halbleiterschichten, der insbesondere epitaktisch gewachsen ist. Das für das epitaktische Wachstum notwendige Aufwachssubstrat ist jedoch von dem Halbleiterschichtstapel vollständig entfernt oder seine Dicke ist zumindest stark reduziert, so dass insbesondere nur ein dünner Rest des Aufwachssubstrats auf dem Halbleiterschichtstapel verbleibt. Auch weist der substratlose Halbleiterschichtstapel vorzugsweise keinen Hilfsträger auf, der ihn mechanisch stützt. Die Dicke des substratlosen Halbleiterschichtstapels ist zweckmäßigerweise kleiner oder gleich 20 µm, bevorzugt kleiner oder gleich 10 µm, beispielsweise beträgt die Dicke des substratlosen Halbleiterschichtstapels etwa 6 µm.

Der substratlose Halbleiterschichtstapel ist dazu geeignet, bei Einprägen eines elektrischen Stroms elektromagnetische Strahlung von seiner Vorderseite zu emittieren. Dazu umfasst der substratlose Halbleiterschichtstapel bevorzugt einen pn-Übergang, eine Doppelheterostruktur, einen Einfach-Quantentopf oder eine Mehrfach-Quantentopfstruktur (MQW) zur Strahlungserzeugung. Die Bezeichnung "Quantentopfstruktur" entfaltet hierbei keine Bedeutung hinsichtlich der Dimensionalität der Quantisierung. Sie umfasst somit u. a. Quantentröge, Quantendrähte und Quantenpunkte und jede Kombination dieser Strukturen. Beispiele für MQW-Strukturen sind in den Druckschriften WO 01/39282, US 5,831,277, US 6,172,382 B1 und US 5,684,309 beschrieben.

An seiner zu dem Trägerkörper hin gewandten, der Vorderseite gegenüberliegenden Rückseite umfasst der Halbleiterschichtstapel bevorzugt eine reflektierende Schicht, zum Beispiel eine metallische Schicht, die zumindest einen Teil der in dem Halbleiterschichtstapel erzeugten elektromagnetischen Strahlung in diesen zurückreflektiert.

Ebenfalls bevorzugt enthält der Halbleiterschichtstapel mindestens eine Halbleiterschicht mit zumindest einer Fläche, die eine Durchmischungsstruktur aufweist, die im Idealfall zu einer annähernd ergodischen Verteilung des Lichtes in dem Halbleiterschichtstapel führt, d.h. sie weist ein möglichst ergodisch stochastisches Streuverhalten auf.

Der substratlose Halbleiterschichtstapel ist in guter Näherung ein Lambert'scher Oberflächenstrahler und eignet sich von daher besonders gut für die Anwendung in einem Scheinwerfer.

Mit Vorteil haben die substratlosen Halbleiterschichtstapel einen geringen Abstand voneinander, so dass eine besonders homogene Leuchtdichteverteilung der Leuchtdiodenanordnung erzielt wird. Insbesondere ragt kein Aufwachssubstrat und/oder Hilfsträger seitlich über den Halbleiterschichtstapel hinaus.

Erfindungsgemäß haben mindestens zwei Halbleiterschichtstapel, vorzugsweise jedoch je zwei zueinander benachbarte Halbleiterschichtstapel einen Abstand von kleiner oder gleich 100 µm. Besonders bevorzugt beträgt der Abstand 50 µm oder weniger. Insbesondere sind also die strahlungsemittierenden Bereiche von zwei benachbarten Halbleiterschichtstapeln jeweils 100 µm oder weniger, bevorzugt 50 µm oder weniger, voneinander entfernt.

Mit Vorteil weist die Leuchtdiodenanordnung mit substratlosen Halbleiterschichtstapeln zudem eine besonders geringe Bauhöhe auf. Der Abstand zwischen der strahlungsemittierenden Vorderseite eines Halbleiterschichtstapels, insbesondere der größte Abstand zwischen den Vorderseiten der Halbleiterschichtstapel und der ersten Hauptfläche des Trägerkörpers, ist kleiner oder gleich 50 µm, bevorzugt kleiner oder gleich 20 µm und besonders bevorzugt kleiner oder gleich 10 µm.

Bei einer vorteilhaften Ausführungsform ist der Halbleiterschichtstapel mit einer Befestigungsschicht an dem Trägerkörper befestigt. Die Befestigungsschicht ist vorzugsweise nur in einem Montagebereich des Halbleiterschichtstapels auf den Trägerkörper aufgebracht. Die Montagebereiche für verschiedene Halbleiterschichtstapel sind disjunkt, das heißt, sie überlappen nicht. Mit anderen Worten bedeckt jede Befestigungsschicht vorzugsweise nur einen Teilbereich der ersten Hauptfläche des Trägerkörpers und überlappt nicht mit einer weiteren Befestigungsschicht.

Beispielsweise sind die Flächeninhalte der der Vorderseite gegenüberliegenden Hauptfläche des Halbleiterschichtstapels und der Befestigungsschicht im wesentlichen gleich groß. Alternativ ragt der Halbleiterschichtstapel seitlich über die Befestigungsschicht hinaus. Anders ausgedrückt bedeckt die Befestigungsschicht in Draufsicht auf die Rückseite des Halbleiterschichtstapels beispielsweise einen Mittelbereich der Rückseite, während ein Randbereich, insbesondere ein umlaufender Randbereich der Rückseite frei von der Befestigungsschicht ist.

Die Befestigungsschicht enthält beispielsweise ein Lötmetall wie AuSn oder besteht daraus.

Bei einer weiteren vorteilhaften Ausführungsform ist auf der ersten Hauptfläche des Trägerkörpers mindestens ein Barriererahmen angeordnet, der eine Befestigungsschicht zumindest stellenweise seitlich begrenzt. Beispielsweise ist eine Mehrzahl von Barriererahmen mittels Stegen auf dem Trägerkörper ausgebildet. Anders ausgedrückt ist auf dem Trägerkörper eine strukturierte Barriereschicht angeordnet, die Öffnungen vom Trägerkörper zum Halbleiterschichtstapel hin aufweist, welche zur Aufnahme der Befestigungsschichten vorgesehen sind. Alternativ kann ein Barriererahmen mittels einer Vertiefung in der Barriereschicht ausgebildet sein.

Bevorzugt umschließt der Barriererahmen eine Befestigungsschicht vollständig. Besonders bevorzugt ist jede Befestigungsschicht von einem Barriererahmen vollständig umschlossen.

Vorteilhafterweise ist die laterale Ausdehnung der Befestigungsschicht auf diese Weise begrenzt. Beispielsweise bei einer elektrisch leitfähigen Befestigungsschicht wird so die Gefahr eines elektrischen Kurzschluss zwischen benachbarten Halbleiterschichtstapeln, die angesichts des geringen Abstands zwischen den Halbleiterstapeln sonst groß wäre, deutlich reduziert.

Bei einer weiteren vorteilhaften Ausführungsform weist der Halbleiterschichtstapel eine elektrisch isolierende Schicht auf, welche seine Rückseite zumindest stellenweise bedeckt. Beispielsweise bedeckt die elektrisch isolierende Schicht in Draufsicht auf die Rückseite einen Randbereich, insbesondere einen umlaufenden Randbereich der Rückseite und lässt einen Mittelbereich davon frei. Bei einer Ausführungsform ist die elektrisch isolierende Schicht dazu vorgesehen, die Befestigungsschicht zumindest stellenweise seitlich zu begrenzen. Besonders bevorzugt umschließt die elektrisch isolierende Schicht die Befestigungsschicht vollständig. Vorteilhafterweise wird so gleichzeitig eine laterale Begrenzung der Befestigungsschicht erzielt. Alternativ oder zusätzlich kann eine weitere elektrisch isolierende Schicht vorgesehen sein, die eine oder mehrere, insbesondere alle Flanken des Halbleiterschichtstapels zumindest stellenweise bedeckt. Beispielsweise ist die elektrisch isolierende Schicht ausgehend von der Rückseite des Halbleiterschichtstapels auch über dessen Flanken gezogen und stellt dort die weitere elektrisch isolierende Schicht dar. Vorteilhafterweise verringert die weitere elektrisch isolierende Schicht die Gefahr eines Kurzschlusses des pn-Übergangs, der Doppelheterostruktur, der Einfach- oder Mehrfachquantentopfstruktur.

Bei einer vorteilhaften Ausführungsform hat der Halbleiterschichtstapel die Form eines Rechtecks oder eines Quadrats. Bei einer weiteren vorteilhaften Ausführungsform sind die Halbleiterschichtstapel in einem Rechteckraster auf dem Trägerkörper angeordnet. Auf diese Weise wird mit Vorteil eine rechteckige Leuchtfläche erzielt. Mit rechteckigen beziehungsweise quadratischen Halbleiterschichtstapeln, die in einem Rechteckraster angeordnet sind, wird eine besonders homogene Leuchtdichte erzielt. Beispielsweise sind die frei bleibenden Bereiche des Trägerkörpers, also die Bereiche, die nicht von Halbleiterschichtstapeln bedeckt sind, sondern zwischen den Halbleiterschichtstapeln liegen, bei dieser Ausführungsform mit Vorteil besonders klein.

Bei einer weiteren Ausführungsform hat das Rechteckraster drei Zeilen und drei Spalten. Die Leuchtdiodenanordnung weist bei dieser Ausführungsform also neun Halbleiterschichtstapel auf, die in drei Zeilen und in drei Spalten nebeneinander angeordnet sind. Die Anzahl der Halbleiterschichtstapel der Leuchtdiodenanordnung ist aber in keiner Weise auf diese Zahl eingeschränkt. Vielmehr kann die Leuchtdiodenanordnung vorteilhafterweise eine beliebige Anzahl von Halbleiterschichtstapeln umfassen, ohne dass eine Beeinträchtigung der Homogenität der Leuchtdichte und/oder der Zuverlässigkeit auftritt.

Bei einer Ausführungsform weist der Halbleiterschichtstapel zwei elektrische Kontaktbereiche auf, die zur elektrischen Kontaktierung auf seiner Vorderseite geeignet sind. Anders ausgedrückt wird der Halbleiterschichtstapel mittels der elektrischen Kontaktbereiche an seiner Vorderseite elektrisch angeschlossen. Insbesondere umfasst jeder der Kontaktbereiche eine elektrische Kontaktfläche, die auf der Vorderseite des Halbleiterschichtstapels angeordnet ist. Zweckmäßigerweise ist ein erster der zwei elektrischen Kontaktbereiche elektrisch leitend mit der Vorderseite des Halbleiterschichtstapels und ein zweiter der zwei elektrischen Kontaktbereiche elektrisch leitend mit der Rückseite des Halbleiterschichtstapels verbunden.

Vorteilhafterweise kann bei einem Halbleiterschichtstapel, der zwei elektrische Kontaktflächen auf seiner Vorderseite aufweist, auf einen elektrischen Anschlussbereich auf dem Trägerkörper verzichtet werden, der neben dem Halbleiterschichtstapel angeordnet ist. Zwischen zwei Halbleiterschichtstapeln muss also kein Platz für einen elektrischen Anschlussbereich verbleiben. Die Halbleiterschichtstapel können bei dieser Ausführungsform daher vorteilhafterweise einander besonders nahe benachbart angeordnet werden. So wird mit Vorteil eine besonders hohe Leuchtdichte und eine besonders homogene Leuchtdichteverteilung erzielt.

Weist eine Mehrzahl von Halbleiterschichtstapeln je zwei elektrische Kontaktbereiche auf, die zur elektrischen Kontaktierung auf ihrer Vorderseite geeignet sind, wird zudem eine besonders zuverlässige elektrische Kontaktierung der Halbleiterschichtstapel erzielt. So genügt es beispielsweise, einen Bond-Draht, mittels dem die elektrische Kontaktierung erfolgt, von einem Halbleiterschichtstapel zu einem benachbarten Halbleiterschichtstapel zu ziehen. Lange Bond-Drähte, die von einem Halbleiterschichtstapel über einen benachbarten Halbleiterschichtstapel hinweg auf den Trägerkörper gezogen werden, sind vorteilhafterweise nicht notwendig. Auf diese Weise wird eine einfache und zuverlässige Verschaltung benachbarter Halbleiterschichtstapel erzielt, sodass die Leuchtdiodenanordnung hinsichtlich der Anordnung und der Anzahl der Halbleiterschichtstapel auf dem Trägerkörper flexibel gestaltet werden kann. Insbesondere sind Leuchtdiodenanordnungen mit einer Vielzahl von Halbleiterschichtstapeln erzielbar, die eine besonders hohe Leuchtdichte und eine besonders homogene Leuchtdichteverteilung aufweisen. Die Halbleiterschichtstapel sind dabei insbesondere in Reihen und Spalten nebeneinander angeordnet.

Bei einer anderen vorteilhaften Ausführungsform weist die Leuchtdiodenanordnung einen elektrischen Anschlussleiter zum elektrischen Anschließen der Halbleiterschichtstapel auf, der eine elektrisch leitende Schicht umfasst, die zwischen einer der ersten Hauptfläche gegenüberliegenden zweiten Hauptfläche des Trägerkörpers und den Halbleiterschichtstapeln angeordnet ist.

Beispielsweise befindet sich die elektrisch leitende Schicht auf der ersten Hauptfläche des Trägerkörpers und bedeckt diese stellenweise oder vollständig. Beispielsweise ist zumindest ein Teil der elektrisch leitenden Schicht in der Öffnungen des Barriererahmens angeordnet. Alternativ oder zusätzlich kann der Barriererahmen zumindest stellenweise auf der elektrisch leitenden Schicht angeordnet sein.

Bei einer Weiterbildung dieser Ausführungsform ist die Befestigungsschicht auf der elektrisch leitenden Schicht angeordnet. Dies ist insbesondere dann von Vorteil, wenn der Halbleiterschichtstapel über seine Rückseite vermittels einer elektrisch leitfähigen Befestigungsschicht elektrisch kontaktiert wird.

Bei einer weiteren vorteilhaften Ausführungsform weist der Trägerkörper eine Mehrschichtstruktur auf. Das heißt, der Trägerkörper weist im Verlauf von der ersten Hauptfläche zur zweiten Hauptfläche eine Mehrzahl von Schichten auf. Bei einer bevorzugten Ausführungsform ist die elektrisch leitende Schicht des elektrischen Anschlussleiters zwischen der ersten Hauptfläche und der zweiten Hauptfläche des Trägerkörpers angeordnet. Mit anderen Worten verläuft die elektrisch leitende Schicht im Inneren des Trägerkörpers. Zweckmäßigerweise umfasst der elektrische Anschlussleiter mindestens eine Durchkontaktierung, die eine elektrisch leitende Verbindung zwischen der elektrisch leitenden Schicht und der ersten Hauptfläche herstellt.

Bevorzugt umfasst der elektrische Anschlussleiter auch eine weitere elektrisch leitende Schicht, die auf der ersten Hauptfläche des Trägerkörpers angeordnet ist und die mit der Durchkontaktierung beziehungsweise den Durchkontaktierungen elektrisch leitend verbunden ist. Beispielsweise ist die Durchkontaktierung und/oder zumindest ein Teilbereich der weiteren elektrisch leitende Schicht zwischen der Rückseite des Halbleiterschichtstapels und der elektrisch leitenden Schicht angeordnet, sodass diese insbesondere elektrisch leitend verbunden werden.

Bevorzugt ist die elektrisch leitende Schicht und/oder die weitere elektrisch leitende Schicht zu, insbesondere voneinander elektrisch isolierten, Teilbereichen strukturiert. Vorzugsweise umfasst sie einzelne Leiterbahnen.

Mit einer im Inneren des Trägerkörpers verlaufenden elektrisch leitenden Schicht ist mit Vorteil eine besonders flexible elektrische Verschaltung der einzelnen Halbleiterschichtstapel möglich. Beispielsweise braucht bei der Führung von Leiterbahnen keine Rücksicht auf die Halbleiterschichtstapel genommen werden, so dass eine Leiterbahn zum Beispiel unter einem Halbleiterschichtstapel hindurch geführt werden kann. So wird beispielsweise eine besonders einfache Ansteuerung von Leuchtdiodenanordnungen erzielt, die eine Vielzahl von Halbleiterschichtstapeln umfassen. Insbesondere ist die Anzahl der Halbleiterschichtstapel der Leuchtdiodenanordnung nicht dadurch begrenzt, dass auf Belange der elektrischen Verschaltung Rücksicht genommen werden muss.

Bei einer alternativen Ausführungsform weist der Halbleiterschichtstapel eine Aussparung auf. Die Aussparung erstreckt sich von der Vorderseite zur Rückseite über die gesamte Dicke des Halbleiterschichtstapels. Beispielsweise hat der Halbleiterschichtstapel bis auf die Aussparung die Form eines Rechtecks oder Quadrats. Anders ausgedrückt fehlt von dem Rechteck oder Quadrat im Bereich der Aussparung ein Teil. Die Aussparung ist beispielsweise an einer Kante oder an einer ersten Ecke des Rechtecks oder Quadrats angeordnet. Sie hat beispielsweise die Form eines Kreissegments, Dreiecks, Rechtecks oder Quadrats. Bei einer vorteilhaften Ausführungsform weist der Halbleiterschichtstapel an einer zweiten Ecke des Rechtecks oder Quadrats einen elektrischen Kontaktbereich auf, der zur elektrischen Kontaktierung an der Vorderseite des Halbleiterschichtstapels geeignet ist. Bei einer Ausgestaltung sind die erste und die zweite Ecke einander benachbart. Bei einer anderen Ausführungsform liegt die zweite Ecke der ersten Ecke diagonal gegenüber.

Bei dieser alternativen Ausführungsform weist der Trägerkörper im Bereich der Aussparung einen elektrischen Anschlussbereich auf. Beispielsweise ist ein Teilbereich der elektrisch leitenden Schicht oder Fläche beziehungsweise der weiteren elektrisch leitenden Schicht oder Fläche in Draufsicht auf die erste Hauptfläche des Trägerkörpers im Bereich der Aussparung angeordnet und stellt den elektrischen Anschlussbereich dar.

Der elektrische Anschlussbereich ist vorzugsweise mit der Rückseite des Halbleiterschichtstapels oder mit den Rückseiten mehrerer Halbleiterschichtstapel elektrisch leitend verbunden. Weist die Leuchtdiodenanordnung einen elektrischen Anschlussleiter mit einer zwischen der ersten und der zweiten Hauptfläche des Trägerkörpers verlaufenden elektrisch leitenden Schicht auf, ist der elektrische Anschlussbereich bei einer Ausführungsform alternativ oder zusätzlich mit der zwischen der ersten und der zweiten Hauptfläche des Trägerkörpers verlaufenden elektrisch leitenden Schicht elektrisch leitend verbunden.

Bei einer weiteren vorteilhaften Ausführungsform ist die Vorderseite des Halbleiterschichtstapels und/oder die erste Hauptfläche des Trägerkörpers zumindest stellenweise von einer elektrisch isolierenden Deckschicht bedeckt.

Bei einer zweckmäßigen Ausführungsform ist die Deckschicht für die von den Halbleiterschichtstapeln im Betrieb der Leuchtdiodenanordnung emittierte elektromagnetische Strahlung zumindest teilweise, insbesondere praktisch vollständig, durchlässig.

Bei einer anderen zweckmäßigen Ausführungsform enthält die Deckschicht ein Lumineszenzkonversionsmaterial. Das Lumineszenzkonversionsmaterial absorbiert zumindest einen Teil der von den Halbleiterschichtstapeln im Betrieb emittierten elektromagnetischen Strahlung (Primärstrahlung) und emittiert selbst wiederum elektromagnetische Strahlung (Sekundärstrahlung), die in der Regel eine andere, insbesondere größere, Wellenlänge aufweist als die Primärstrahlung.

Vorzugsweise emittiert die Leuchtdiodenanordnung mischfarbiges Licht, das unkonvertierte elektromagnetische Strahlung von den Halbleiterschichtstapeln und konvertierte elektromagnetische Strahlung vom Lumineszenzkonversionsmaterial umfasst. Alternativ ist auch denkbar, dass die Leuchtdiodenanordnung kein Mischlicht emittiert, sondern das Lumineszenzkonversionsmaterial die Spektralverteilung der Strahlung verschiebt. Das Lumineszenzkonversionsmaterial enthält beispielsweise einen anorganischen Leuchtstoff, etwa einen Granatleuchtstoff, der insbesondere mit einer oder mehreren seltenen Erden dotiert ist. Daneben sind mit seltenen Erden dotierte Erdalkalisulfide, Thiogalate, Aluminate und/oder Orthosilikate denkbar. Bei einer weiteren vorteilhaften Ausführungsform enthält die Deckschicht einen Farbstoff, der beispielsweise dazu geeignet ist, einen Teil des von dem Halbleiterschichtstapels emittierten Lichts zu absorbieren.

Besonders bevorzugt emittiert die Leuchtdiodenanordnung Licht, das einen weißen Farbeindruck erzeugt. Dazu enthält sie vorzugsweise mindestens einen Halbleiterschichtstapel, der elektromagnetische Strahlung im blauen und/oder ultravioletten Spektralbereich emittiert und mindestens ein Lumineszenzkonversionsmaterial das zumindest einen Teil der blauen und/oder ultravioletten Strahlung des Halbleiterschichtstapels in elektromagnetischer Strahlung größerer Wellenlänge, beispielsweise im gelben oder orangen Spektralbereich, umwandelt. Emittiert der Halbleiterschichtstapel beispielsweise nicht oder nicht mit hinreichender Intensität im blauen Spektralbereich sondern überwiegend oder ausschließlich im ultravioletten Spektralbereich, enthält die Deckschicht vorzugsweise ein weiteres Lumineszenzkonversionsmaterial, das dazu geeignet ist, ultraviolette Strahlung in blaues Licht umzuwandeln. Alternativ sind jedoch auch ein- oder mehrfarbige Leuchtdiodenanordnungen möglich, die mindestens einen Halbleiterschichtstapel enthalten, der rotes, grünes, gelbes oder blaues Licht emittiert.

Bei einer zweckmäßigen Ausführungsform lässt die Deckschicht elektrische Kontaktbereiche und/oder elektrische Anschlussbereiche zumindest teilweise frei. Um das zu erzielen, wird die Deckschicht von den elektrischen Kontaktbereichen und/oder elektrischen Anschlussbereichen zumindest stellenweise entfernt, was beispielsweise mittels Laserablation erfolgen kann. Alternativ kann sie auch strukturiert aufgebracht sein, beispielsweise durch eine Maske hindurch, die die elektrischen Kontaktbereiche und/oder elektrischen Anschlussbereiche während der Herstellung der Deckschicht zumindest stellenweise bedeckt.

Auf der vom Trägerkörper abgewandten Seite der Deckschicht ist bei einer besonders vorteilhaften Ausführungsform eine elektrische Kontaktierungsschicht angeordnet. Die elektrische Kontaktierungsschicht bedeckt bevorzugt die von der Deckschicht freigelassenen elektrischen Kontaktbereiche und/oder elektrischen Anschlussbereiche und ist insbesondere elektrisch leitend mit diesen verbunden. Bei einer Ausführungsform ist die elektrische Kontaktierungsschicht strukturiert, beispielsweise zu Teilbereichen wie Leiterbahnen, die insbesondere elektrisch voneinander isoliert sind. Beispielsweise verbindet sie zwei elektrische Kontaktbereiche, einen elektrischen Kontaktbereich und einen elektrischen Anschlussbereich und/oder zwei elektrische Anschlussbereiche elektrisch leitend miteinander. Vorzugsweise bedeckt die Kontaktschicht den Halbleiterschichtstapel nur in einem Randbereich, beispielsweise bedeckt die Kontaktschicht nur den ersten und/oder den zweiten elektrischen Kontaktbereich.

Mit Vorteil wird mit der elektrischen Kontaktierungsschicht eine besonders Platz sparende Kontaktierung der Halbleiterschichtstapel erzielt, sodass die Leuchtdiodenanordnung vorteilhafterweise eine besonders geringe Bauhöhe aufweisen kann.

Bei einer Abwandlung weist der Halbleiterschichtstapel zwei Kontaktbereiche auf, die zur elektrischen Kontaktierung auf seiner dem Trägerkörper zugewandten Rückseite geeignet sind. Insbesondere umfasst jeder der Kontaktbereiche eine elektrische Kontaktfläche, die auf der Rückseite des Halbleiterschichtstapels angeordnet ist. Analog zu einer Ausführungsform mit zwei Kontaktbereichen, die zur elektrischen Kontaktierung auf der Vorderseite geeignet sind, ist zweckmäßigerweise ein erster der zwei elektrischen Kontaktbereiche, elektrisch leitend mit der Vorderseite des Halbleiterschichtstapels und ein zweiter der zwei elektrischen Kontaktbereiche elektrisch leitend mit der Rückseite des Halbleiterschichtstapels verbunden.

Vorteilhafterweise kann bei einem Halbleiterschichtstapel, der zwei elektrische Kontaktflächen auf seiner Rückseite aufweist, auf Bonddrähte und elektrische Kontaktierungsschichten auf der Vorderseite des Halbleiterkörpers, die beispielsweise die Leuchtdichte verringern und/oder deren Homogenität beeinträchtigen könnten, verzichtet werden. Die elektrische Kontaktierung des Halbleiterkörpers erfolgt stattdessen bereits bei der Montage auf dem Trägerkörper.

Wird die Verbindung mit dem Trägerkörper mittels Befestigungsschichten hergestellt, ist jeder der beiden auf der Rückseite des Halbleiterschichtstapels angeordneten Kontaktflächen zweckmäßigerweise eine separate Befestigungsschicht zugeordnet.

Bei einem Verfahren zum Herstellen einer Leuchtdiodenanordnung gemäß der Erfindung wird ein Trägerkörper mit einer Mehrzahl von Montagebereichen, die in Draufsicht auf eine erste Hauptfläche des Trägerkörpers nebeneinander angeordnet sind, bereitgestellt und, zu gleichen Zeiten oder sequentiell, in jedem Montagebereich
- eine Befestigungsschicht auf der ersten Hauptfläche des Trägerkörpers ausgebildet,
- ein Halbleiterchip, der dazu vorgesehen ist, von seiner Vorderseite elektromagnetische Strahlung zu emittieren, so auf der Befestigungsschicht platziert wird, dass seine Vorderseite von der Befestigungsschicht abgewandt ist,
- der Halbleiterchip auf der Befestigungsschicht ausgerichtet und
- eine mechanisch stabile Verbindung zwischen dem Halbleiterchip und dem Trägerkörper mittels der Befestigungsschicht hergestellt, wobei der Halbleiterchip aus einem substratlosen Halbleiterschichtstapel besteht und kein Hilfsträger zwischen dem Halbleiterschichtstapel und dem Trägersubstrat angeordnet wird. Der Abstand zwischen der Vorderseite des Halbleiterschichtstapels und der ersten Hauptfläche des Trägerkörpers ist dabei kleiner oder gleich 50 µm. Je zwei zueinander benachbarte Halbleiterschichtstapel werden dabei in Draufsicht auf die erste Hauptfläche des Trägerkörpers gesehen in einem Abstand von kleiner oder gleich 100 µm angeordnet. Die Halbleiterschichtstapel werden in Reihe geschaltet, wobei entweder die Halbleiterschichtstapel je zwei elektrische Kontaktbereiche aufweisen, die zum elektrischen Anschließen des jeweiligen Halbleiterschichtstapels auf seiner Vorderseite angeordnet sind oder wobei die Halbleiterschichtstapel je einen elektrischen Kontaktbereich sowie eine Aussparung aufweisen, wobei der elektrische Kontaktbereich zum elektrischen Anschließen des Halbleiterschichtstapels an seiner Vorderseite angeordnet ist und wobei dann der Trägerkörper im Bereich der Aussparungen einen Anschlussbereich aufweist, der mit der Rückseite des Halbleiterschichtstapels elektrisch leitend verbunden ist.

Beispielsweise wird die Befestigungsschicht in flüssiger Form auf den Trägerkörper aufgebracht und/oder geschmolzen oder anderweitig verflüssigt bevor oder nachdem der Halbleiterschichtstapel mit ihr in Kontakt gebracht wird.

Das Ausrichten des Halbleiterschichtstapels erfolgt vorzugsweise auf der flüssigen Befestigungsschicht. Bei einer vorteilhaften Ausführungsform richtet sich der Halbleiterschichtstapel selbstständig auf Befestigungsschicht aus, während diese in flüssiger Form vorliegt. Vorzugsweise richtet sich der Halbleiterschichtstapel mittig auf der flüssigen Befestigungsschicht aus. Ohne an eine bestimmte Erklärung gebunden zu sein, wird angenommen, dass dies aufgrund der Oberflächenspannung der flüssigen Befestigungsschicht und/oder aufgrund von Adhäsionskräften erfolgt. Bei der mittigen Ausrichtung befinden sich die Projektionen der Schwerpunkte des Halbleiterschichtstapels und der Befestigungsschicht in Draufsicht auf die erste Hauptfläche nach dem Ausrichten im Wesentlichen an der gleichen Stelle.

Eine besonders gute Ausrichtung des Halbleiterschichtstapels wird mit Vorteil bei einer Ausführungsform erreicht, bei der das Verfahren das Herstellen eines Barriererahmens auf dem Trägerkörper umfasst. Die Befestigungsschicht wird vorzugsweise in der Öffnung des Barriererahmens hergestellt, so dass die laterale Ausdehnung der Befestigungsschicht durch den Barriererahmen zumindest stellenweise begrenzt ist. Vorzugsweise umschließt der Barriererahmen die Befestigungsschicht vollständig. Insbesondere verringert er die Gefahr eines Verlaufens der flüssigen Befestigungsschicht aus dem Montagebereich heraus. Die Öffnung hat vorzugsweise einen kreisförmigen, rechteckigen oder quadratischen Querschnitt. Vorteilhafterweise wird so eine gute Reproduzierbarkeit der Position und der Form der Befestigungsschicht im Montagebereich erzielt.

Bei einer weiteren vorteilhaften Ausführungsform des Verfahrens wird eine Passivierungsschicht auf einem Randbereich der Rückseite des Halbleiterschichtstapels hergestellt, bevor dieser auf der Befestigungsschicht platziert wird. Beispielsweise unterscheiden sich die Oberflächeneigenschaften des Halbleiterschichtstapels und der Passivierungsschicht. Bei einer Ausführungsform benetzt die Befestigungsschicht die Rückseite des Halbleiterschichtstapels, aber nicht die Passivierungsschicht. So wird vorteilhafterweise die Ausrichtung des Halbleiterschichtstapels auf der Befestigungsschicht weiter verbessert.

Die mechanisch stabile Verbindung zwischen dem Halbleiterschichtstapel und dem Trägerkörper wird beispielsweise durch Erstarren der Befestigungsschicht, also durch den Übergang vom flüssigen in den festen Aggregatszustand, hergestellt, beispielsweise bei einer Befestigungsschicht die ein Lot aufweist. Alternativ wird sie durch Aushärten der Befestigungsschicht hergestellt, beispielsweise wenn diese einen Klebstoff aufweist.

Bei einer weiteren bevorzugten Ausführungsform des Verfahrens wird eine Aussparung in dem Halbleiterkörper erzeugt. Dies erfolgt insbesondere vor dessen Platzierung auf der Befestigungsschicht. Die Aussparung kann beispielsweise mittels eines Sägeverfahrens (z. B. mit einem Diamantsägeblatt), bei dem ein Teil des Halbleiterkörpers von diesem herausgesägt wird oder mittels eines Ätzverfahrens (nasschemisches Ätzen und/oder Trockenätzen) erzeugt werden. Bevorzugt wird die Aussparung mittels Lasertrennen (auch "laser dicing" genannt), also durch Abtrennen eines Teils des Halbleiterkörpers mittels Laserstrahlung, erzeugt. Beispielsweise wird von einem ursprünglich rechteckigen oder quadratischen Halbleiterkörper eine Ecke entfernt.

Bei einer vorteilhaften Ausführungsform des Verfahrens wird ein Trägerkörper mit einem elektrischen Anschlussbereich bereitgestellt, der nach dem Ausrichten des Halbleiterschichtstapels mit der Aussparung überlappt, sodass sich nach dem Ausrichten die Aussparung zumindest teilweise über dem elektrischen Anschlussbereich befindet.

Weitere Vorteile und vorteilhafte Ausführungsformen, Weiterbildungen und Abwandlungen der Erfindung ergeben sich aus den im Folgenden in Verbindung mit den Figuren 1A bis 5 beschriebenen Ausführungsbeispielen.

Es zeigen:
- Figuren 1A bis 1C,: schematische Schnittdarstellungen von verschiedenen Stadien des Verfahrens zum Herstellen einer Leuchtdiodenanordnung gemäß einem ersten Ausführungsbeispiel,
- Figur 2,: eine schematische Schnittdarstellung eines Ausschnitts aus einer Leuchtdiodenanordnung gemäß einem zweiten Ausführungsbeispiel;
- Figur 3,: eine schematische Schnittdarstellung eines Ausschnitts aus einer Leuchtdiodenanordnung gemäß einem dritten Ausführungsbeispiel;
- Figur 4A,: eine schematische Draufsicht auf die Leuchtdiodenanordnung gemäß dem dritten Ausführungsbeispiel;
- Figur 4B,: eine schematische Draufsicht auf eine Variante der Leuchtdiodenanordnung gemäß dem Ausführungsbeispiel der Figur 4A;
- Figur 5,: eine schematische Schnittdarstellung eines Ausschnitts aus einer Leuchtdiodenanordnung gemäß einer Abwandlung; und
- Figur 6,: eine schematische Schnittdarstellung eines Ausschnitts aus einer Leuchtdiodenanordnung gemäß einer weiteren Abwandlung.

In den Figuren sind gleiche oder gleich wirkende Bestandteile jeweils mit den gleichen Bezugszeichen versehen. Die dargestellten Elemente und deren Größenverhältnisse untereinander sind grundsätzlich nicht als maßstabsgerecht anzusehen, vielmehr können einzelne Elemente, wie z. B. Schichten und/oder Abstände, zur besseren Darstellbarkeit und/oder zum besseren Verständnis übertrieben groß beziehungsweise dick dargestellt sein.

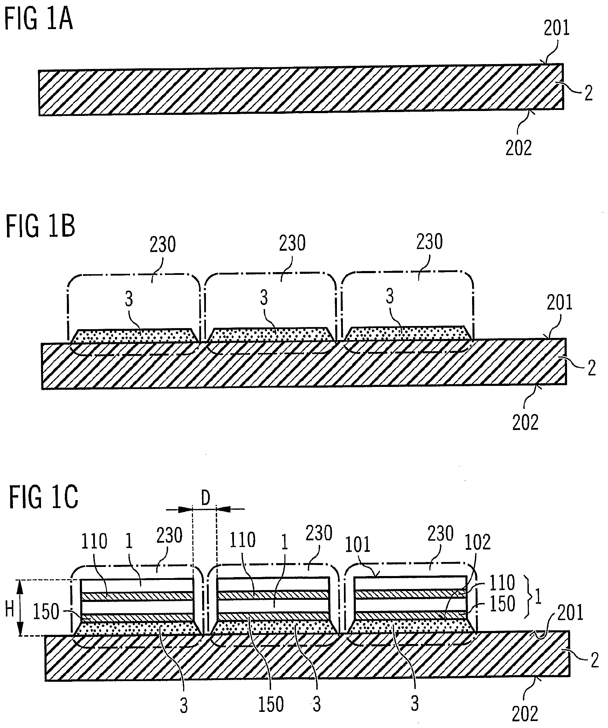

Bei dem Verfahren zur Herstellung einer Leuchtdiodenanordnung gemäß dem ersten Ausführungsbeispiel wird zunächst ein Trägerkörper 2 bereitgestellt(siehe Figur 1A). Vorliegend handelt es sich bei dem Trägerkörper um eine gedruckte Leiterplatte (printed circuit board, PCB). Es sind aber auch andere Trägerkörper denkbar. Beispielsweise kann alternativ eine Platte als Trägerkörper verwendet werden, die ein Kunststoffmaterial, ein Glas, ein keramisches Material oder ein Metall aufweist.

Nachfolgend wird auf einer ersten Hauptfläche 201 des Trägerkörpers 2, also auf einer der zur Haupterstreckungsebene des Trägerkörpers 2 zumindest im Wesentlichen parallelen Flächen des Trägerkörpers 2, eine Mehrzahl von Befestigungsschichten 3 ausgebildet. Jede der Befestigungsschichten 3 ist vollständig innerhalb eines Montagebereichs 230 des Trägerkörpers 2 angeordnet. Die Montagebereiche 230 sind disjunkt, sie überlappen also nicht. Auch die einzelnen Befestigungsschichten 3 berühren sich nicht gegenseitig und sie überlappen auch nicht. Beispielsweise enthalten die Befestigungsschichten 3 ein Lötmetall, beispielsweise Sn, AgSn oder AuSn, und sind mit einer Leiterbahn eines elektrischen Anschlussleiters, der zur elektrischen Kontaktierung der Halbleiterschichtstapel vorgesehen ist, (nicht gezeigt) elektrisch leitend verbunden. Die Leiterbahn ist insbesondere ein Teilbereich einer elektrisch leitenden Schicht 9 des elektrischen Anschlussleiters, die auf der ersten Hauptfläche 201 des Trägerkörpers 2 ausgebildet ist. Die Schichtdicke der elektrisch leitenden Schicht 9 ist vorzugsweise kleiner oder gleich 20 µm, besonders bevorzugt kleiner oder gleich 2 µm.

In einem nachfolgenden Verfahrensschritt wird auf jeder der Befestigungsschichten 3 je ein substratloser Halbleiterschichtstapel 1 angeordnet. Beispielsweise kommt hierzu ein pick-and-place Verfahren zum Einsatz. Zum Beispiel werden die Halbleiterschichtstapel 1 auf mindestens einem Zwischenträger, etwa auf einem Saphir-Substrat oder einer Folie bereitgestellt, von diesem bzw. dieser abgelöst und - vor oder nach dem Ablösen - auf den Befestigungsschichten 3 abgelegt. Als Folie ist beispielsweise eine so genannte UV-Release-Folie oder eine so genannte Thermo-Release-Folie geeignet. Bei einer UV- oder Thermo-Release-Folie ist insbesondere das Ablösen der Halbleiterschichtstapel 1 von der UV-Release-Folie nach deren Bestrahlung mit ultravioletter Strahlung beziehungsweise von der Thermo-Release-Folie nach deren Erwärmung erleichtert. Beispielsweise ist nach der Bestrahlung beziehungsweise Erwärmung die Haftung der Halbleiterschichtstapel 1 an der Folie reduziert. Wird bei dem Verfahren eine UV- oder Thermorelease-Folie als Zwischenträger verwendet umfasst das Verfahren vorzugsweise einen Verfahrensschritt, bei dem die UV- bzw. Thermo-Release-Folie vor dem Ablösen der Halbleiterschichtstapel 1 mit UV-Strahlung bestrahlt bzw. erwärmt wird.

Die substratlosen Halbleiterschichtstapel 1 sind zur Emission von elektromagnetischer Strahlung von ihrer Vorderseite 101 vorgesehen. Dazu umfassen sie eine aktive Schicht 110, die vorliegend eine Quantentopfstruktur aufweist. Die Halbleiterschichtstapel 1 basieren beispielsweise auf einem III/V-Verbindungs-Halbleitermaterial, wie einem Nitrid-Verbindungshalbleitermaterial, oder auf einem II-VI-Halbleitermaterial.

Ein III/V-Verbindungs-Halbleitermaterial weist wenigstens ein Element aus der dritten Hauptgruppe, wie beispielsweise Al, Ga, In, und ein Element aus der fünften Hauptgruppe, wie beispielsweise B, N, P, As, auf. Insbesondere umfasst der Begriff "III/V-Verbindungs-Halbleitermaterial" die Gruppe der binären, ternären oder quaternären Verbindungen, die wenigstens ein Element aus der dritten Hauptgruppe und wenigstens ein Element aus der fünften Hauptgruppe enthalten, insbesondere Nitrid- und Phospid-Verbindungshalbleiter. Eine solche binäre, ternäre oder quaternäre Verbindung kann zudem beispielsweise ein oder mehrere Dotierstoffe sowie zusätzliche Bestandteile aufweisen.

Entsprechend weist ein II/VI-Verbindungs-Halbleitermaterial wenigstens ein Element aus der zweiten Hauptgruppe, wie beispielsweise Be, Mg, Ca, Sr, und ein Element aus der sechsten Hauptgruppe, wie beispielsweise O, S, Se, auf. Insbesondere umfasst ein II/VI-Verbindungs-Halbleitermaterial eine binäre, ternäre oder quaternäre Verbindung, die wenigstens ein Element aus der zweiten Hauptgruppe und wenigstens ein Element aus der sechsten Hauptgruppe umfasst. Eine solche binäre, ternäre oder quaternäre Verbindung kann zudem beispielsweise ein oder mehrere Dotierstoffe sowie zusätzliche Bestandteile aufweisen. Beispielsweise gehören zu den II/VI-Verbindungs-Halbleitermaterialien: ZnO, ZnMgO, CdS, ZnCdS, MgBeO.

"Auf Nitrid-Verbindungshalbleitern basierend" bedeutet im vorliegenden Zusammenhang, dass der Halbleiterschichtstapel 1, oder zumindest eine Schicht davon, ein Nitrid-III-Verbindungshalbleitermaterial, vorzugsweise AlₙGaₘIn₁₋ₙ₋ₘN umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es ein oder mehrere Dotierstoffe sowie zusätzliche Bestandteile aufweisen. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

Der Halbleiterschichtstapel 1 umfasst beispielsweise an seiner Rückseite 102, also an der im wesentlichen parallel zu seiner Haupterstreckungsebene verlaufenden Fläche, die der strahlungsemittierenden Vorderseite 101 gegenüber liegt, eine metallische Schicht 150. Die metallische Schicht 150 enthält ein Metall, beispielsweise Ag, oder besteht daraus. Vorzugsweise umfasst die metallische Schicht 150 eine der Vorderseite 101 benachbarte Schicht, die aus Ag besteht und eine von der Vorderseite 101 abgewandte Schicht, die eine Diffusionsbarriere für das Lötmetall der Befestigungsschicht 3 darstellt und die insbesondere TiWN und/oder Ti/Pt enthält oder daraus besteht. Die Schichtdicke der metallischen Schicht 150 hat beispielsweise einen Wert von kleiner oder gleich 5 µm, vorzugsweise von kleiner oder gleich 2 µm, vorzugsweise hat die metallisch Schicht 150 eine Schichtdicke von etwa 1 µm.

Die metallische Schicht 150 vermittelt eine besonders gute Haftung zwischen dem Halbleiterschichtstapel 1 und der Befestigungsschicht 3, beispielsweise ist die metallische Schicht 150 oder zumindest deren von dem Halbleiterschichtstapel 1 abgewandte Fläche besonders gut von dem Lötmetall der Befestigungsschicht 3 benetzbar. Zudem weist die metallische Schicht 150, insbesondere die der Vorderseite 101 benachbarte Schicht, vorzugsweise gute Reflexionseigenschaften auf. Zumindest ein Teil der Strahlung, die von der aktiven Schicht 110 im Betrieb in Richtung der metallischen Schicht 150 emittiert wird, wird von letzterer in Richtung der Vorderseite 101 reflektiert, so dass die Strahlungsemission von der Vorderseite 101 des Halbleiterschichtstapels 1 bei einem Halbleiterschichtstapel 1 mit metallischer Schicht 150 mit Vorteil erhöht ist. Die metallische Schicht 150 stellt also vorliegend unter anderem eine Reflektorschicht dar.

Die Halbleiterschichtstapel 1 sind mittels eines epitaktischen Wachstumsverfahrens auf einem Aufwachssubstrat hergestellt, wobei die Rückseite 102 des Halbleiterschichtstapels 1 üblicherweise vom Aufwachssubstrat abgewandt sind. Das Aufwachssubstrat ist jedoch, beispielsweise mit einem Laser-Abhebe-Verfahren (Laser-liftoff, LLO) von dem Halbleiterschichtstapel entfernt. Alternativ kann der Halbleiterschichtstapel 1 auch noch einen, insbesondere dünnen, Rest des Aufwachssubstrats aufweisen. Im Gegensatz zu herkömmlichen Halbleiterkörpern, bei denen das Aufwachssubstrat entfernt ist, ist kein Hilfsträger auf der Rückseite 102 des Halbleiterschichtstapels angeordnet.

Die, senkrecht zu seiner Haupterstreckungsebene gemessene, Dicke des Halbleiterschichtstapels 1 ist beispielsweise kleiner oder gleich 20 µm, insbesondere kleiner oder gleich 10 µm, vorliegend beträgt sie ca. 6 µm.

Der Abstand H zwischen der ersten Hauptfläche 201 des Trägerkörpers 2 und der Vorderseite 101 der Halbleiterschichtstapel 1 ist daher beispielsweise kleiner oder gleich 25 µm, bevorzugt kleiner oder gleich 15 µm, vorliegend beträgt er ca. 10 µm.

In Draufsicht auf die erste Hauptfläche 201 des Trägerkörpers 2 haben benachbarte Halbleiterschichtstapel 1 zueinander einen Abstand D von kleiner oder gleich 100 µm. Bei dem vorliegenden Ausführungsbeispiel ist der Abstand D etwa 50 µm.

Zum Ausrichten der Halbleiterschichtstapel 1 auf dem Trägerkörper 2 werden die Befestigungsschichten 3 vorliegend zu gleichen Zeiten durch Beaufschlagung mit Wärme geschmolzen.

In jedem Montagebereich 230 richtet sich der Halbleiterschichtstapel 1 mittig auf der jeweiligen geschmolzenen Befestigungsschicht 3 aus. Ohne an eine bestimmte Erklärung gebunden zu sein, wird die Ausrichtung durch die Oberflächenspannung der geschmolzenen Befestigungsschicht 3 und durch Adhäsionskräfte zwischen der metallischen Schicht 150 und der Befestigungsschicht 3 vermittelt. Insbesondere ermöglicht die geringe Dicke und damit auch das geringe Gewicht des Halbleiterschichtstapels 1, der kein Substrat oder nur ein gedünntes Substrat aufweist, und der nicht auf einem separaten Hilfsträger befestigt ist, die selbstständige Ausrichtung auf der geschmolzenen Befestigungsschicht 3.

Anschließend kühlen die Befestigungsschichten 3 wieder ab. Dabei erstarrt in jedem Montagebereicht 230 die Befestigungsschicht 3 und stellt so eine innige Verbindung zwischen der metallischen Schicht 150 des Halbleiterschichtstapels 1 und dem Trägerkörper 2 her. Dabei werden die substratlosen Halbleiterschichtstapel 1 mit dem Trägerkörper 2 mechanisch stabil, und vorliegend auch elektrisch leitend, verbunden.

Alternativ zu einer Befestigungsschicht, die ein Lötmetall aufweist, kann die Befestigungsschicht 3 beispielsweise auch einen Klebstoff aufweisen. Der Klebstoff, insbesondere ein Klebstoff auf Epoxidharz-Basis, ist beispielsweise durch Bestrahlen mit elektromagnetischer Strahlung, beispielsweise im infraroten und/oder ultravioletten Spektralbereich, und/oder durch Erwärmen aushärtbar.

Befestigungsschichten 3, die einen Klebstoff aufweisen, können beispielsweise in flüssiger Form auf den Trägerkörper 2 aufgebracht werden. Nach dem Platzieren der Halbleiterschichtstapel 1 und deren selbstständiger mittiger Ausrichtung auf den Klebstoffschichten 3 in den Montagebereichen 230, analog zu den oben beschriebenen Verfahrensschritten, erfolgt die Aushärtung des Klebstoffs. Dies kann beispielsweise mittels Bestrahlung mit elektromagnetischer Strahlung geschehen. Bevorzugt ist der Trägerkörper 2 für die elektromagnetische Strahlung, die zum Aushärten des Klebstoffs benutzt wird, zumindest teilweise durchlässig. Beispielsweise kommt bei dieser Ausführungsform ein Trägerkörper 2 zum Einsatz, der eine Kunststoff- oder Glasplatte ist. Eine solche Ausführungsform ist insbesondere dann zweckmäßig, wenn keine elektrische Kontaktierung der Halbleiterkörper 1 mittels des Trägerkörpers 2 vorgesehen ist.

Die Befestigungsschichten 3 und der Trägerkörper 2 sind bei einer Ausgestaltung zumindest teilweise durchlässig für von den Halbleiterkörpern 1 im Betrieb emittierte Strahlung. Bei dieser Ausgestaltung ist die Leuchtdiodenanordnung vorzugsweise zur Emission durch den Trägerkörper 2 vorgesehen.

Bei einer weiteren Ausgestaltung ist der Klebstoff zur elektrischen Kontaktierung der Halbleiterkörper 1 mit einem elektrischen Anschlussleiter des Trägerkörpers 2 vorgesehen. Beispielsweise ist ein mit elektrisch leitfähigen Partikeln gefüllter Klebstoff, insbesondere Epoxidharzklebstoff, der insbesondere thermisch und/oder mittels ultravioletter Strahlung aktivierbar ist, hierfür geeignet. Insbesondere handelt es sich um einen mit Ag-Partikeln gefüllten Klebstoff.

Bei einer Ausgestaltung ist die Partikelgröße der elektrisch leitfähigen Partikel kleiner oder gleich 10 µm, vorzugsweise kleiner oder gleich 5 µm, besonders bevorzugt kleiner oder gleich 2 µm. Mit Vorteil ist auf diese Weise trotz der kleinen lateralen Abstände der Halbleiterschichtstapel 1 die Gefahr eines elektrischen Kurzschlusses gering. Zugleich wird vorteilhafterweise eine hohe Parallelität des Halbleiterschichtstapels 1 zu dem Trägerkörper 2 erzielt.

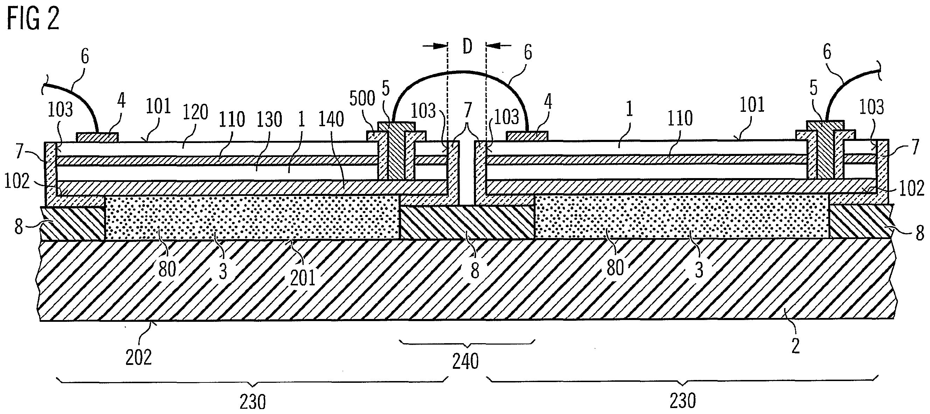

Die Leuchtdiodenanordnung gemäß dem in Figur 2 dargestellten zweiten Ausführungsbeispiel weist im Gegensatz zu der Leuchtdiodenanordnung gemäß dem ersten Ausführungsbeispiel der Figur 1C eine Barriereschicht 8 auf, die auf der ersten Hauptfläche 201 des Trägerkörpers 2 angeordnet ist.

Die Barriereschicht 8 ist strukturiert, so dass sie in jedem Montagebereich einen Barriererahmen mit einer Öffnung 80 darstellt, in der die Befestigungsschicht 3 in Draufsicht auf die erste Hauptfläche 201 angeordnet ist. In Richtung von dem Trägerkörper 2 zu den Halbleiterschichtstapeln 1 ragen die Befestigungsschichten 3 über die Barriereschicht 8 hinaus. Vorteilhafterweise begrenzen die Öffnungen 80 die Ausdehnung der Befestigungsschichten 3 in ihrer Haupterstreckungsebene. So können die flüssigen, insbesondere geschmolzenen Befestigungsschichten 3 nicht aus dem Montagebereich 230 heraus fließen. Insbesondere bei elektrisch leitfähigen Befestigungsschichten 3, wird die Gefahr einer mögliche Berührung benachbarter Befestigungsschichten 3, und damit ein Kurzschluss zwischen diesen, die sonst wegen des geringen Abstands D zwischen den Halbleiterschichtstapeln 1 groß wäre, verringert. Vorteilhafterweise legen die Öffnungen 80 der Barriererahmen 8 die Positionen der Befestigungsschichten 3 in Draufsicht auf die erste Hauptfläche 201 fest, auch wenn die Befestigungsschichten 3 in flüssiger Form vorliegen.

Zudem wird mit der lateralen Begrenzung der Befestigungsschicht 3 durch die Barriererahmen 8 erreicht, dass der Halbleiterschichtstapel 1 in Draufsicht auf die erste Hauptfläche 201 des Trägerkörpers 2 seitlich über die Befestigungsschicht 3 hinausragt. So wird trotz eines geringen Abstandes D zwischen benachbarten Halbleiterschichtstapeln 1 ein größerer Abstand zwischen benachbarten Befestigungsschichten 3 erzielt. Es verbleibt ein Bereich 240 des Trägerkörpers 2 zwischen zwei Befestigungsschichten 3, in denen der Trägerkörper 2 in Draufsicht auf seine erste Hauptfläche 201 nicht von einer Befestigungsschicht 3 bedeckt ist. Der Bereich 240 ist jedoch zweckmäßigerweise zumindest stellenweise von mindestens einem Halbleiterschichtstapel 1 bedeckt.

Trotz des geringen Abstands D zwischen benachbarten Halbleiterschichtstapeln 1 hat der Bereich 240 mit Vorteil parallel zur Haupterstreckungsebene des Trägerkörpers 2 eine Ausdehnung, die groß genug ist, dass zum Beispiel eine Leiterbahn in diesem Bereich 240 geführt werden kann. Die Leiterbahn ist beispielsweise zwischen der Barriereschicht 8 und dem Trägerkörper 2 angeordnet. Sie ist jedoch vorteilhafterweise von den Befestigungsschichten 3 beabstandet, so dass kein elektrischer Kurzschluss entsteht.

Bei jedem Halbleiterschichtstapel 1 gemäß dem zweiten Ausführungsbeispiel ist zudem ein umlaufender Randbereich der Rückseite 102 des Halbleiterschichtstapels 1 mit einer Isolierschicht 7, also mit einer Schicht, die elektrisch isoliert, bedeckt. Beispielsweise handelt es sich bei der Isolierschicht 7 um eine Passivierungsschicht. Die Isolierschicht 7 weist vorzugsweise ein Siliziumoxid wie SiO₂, ein Siliziumnitrid wie Si₃N₄ und/oder bis-Benzocyklobuten (BCB) auf oder besteht aus mindestens einem dieser Materialien. Die Isolierschicht 7 kann amorph oder polykristallin sein oder sowohl amorphe als auch polykristalline Anteile haben.

Bei dem vorliegenden Ausführungsbeispiel erstreckt sich die Isolierschicht 7 auch über die Flanken 103 des Halbleiterschichtstapels 1. So verringert die Isolierschicht 7 beispielsweise die Gefahr eines Kurzschlusses, beispielsweise falls sich zwei benachbarte Halbleiterschichtstapel 1 berühren.

Die elektrische Kontaktierung der Halbleiterschichtstapel 1 erfolgt bei dem zweiten Ausführungsbeispiel von der Vorderseite 101 der Halbleiterschichtstapel 1. Dazu ist bei jedem Halbleiterschichtstapel 1 auf einer der Vorderseite 101 benachbarten n-Kontaktschicht 120 ein erster elektrischer Kontaktbereich 4, etwa ein Bond-Pad, angeordnet. Ein zweiter Kontaktbereich 5 verläuft von der Vorderseite 101 des Halbleiterschichtstapels 1 durch die n-Kontaktschicht 120, die aktive Schicht 110 und eine p-seitige Ladungsträgereinschlussschicht (confinement layer) 130 hindurch und ist gegen diese mit einer Passivierungsschicht 500 elektrisch isoliert. Er erstreckt sich zu einer p-seitigen Stromaufweitungsschicht 140 des Halbleiterschichtstapels 1, die dessen Rückseite 102 benachbart ist. Der erste Kontaktbereich 4 ist also zur n-seitigen elektrischen Kontaktierung des Halbleiterschichtstapels 1 und der zweite Kontaktbereich 5 zur p-seitigen elektrischen Kontaktierung des Halbleiterschichtstapels 1 vorgesehen.

Ein Bond-Draht 6 verbindet eine auf der Vorderseite 101 eines ersten Halbleiterschichtstapels 1 angeordnete Kontaktfläche des zweiten Kontaktbereichs 5 mit dem ersten Kontaktbereich 4 eines zweiten, dem ersten benachbarten Halbleiterschichtstapels 1. Die so verschalteten Halbleiterschichtstapel 1 sind also in Reihe geschaltet.

Bei mindestens einem Halbleiterschichtstapel 1, der am Rand der Leuchtdiodenanordnung angeordnet ist, wird der erste Kontaktbereich 4 beispielsweise mit einer elektrischen Anschlussstelle auf dem Trägerkörper 2 - etwa mittels eines Bonddrahts 6 - elektrisch leitend verbunden. Bei mindesten einem weiteren Halbleiterschichtstapel 1, der am Rand der Leuchtdiodenanordnung angeordnet ist, wird der zweite Kontaktbereich 5 beispielsweise mit einer weiteren elektrischen Anschlussstelle auf dem Trägerkörper 2, beispielsweise ebenfalls mittels eines Bonddrahts 6, elektrisch leitend verbunden.

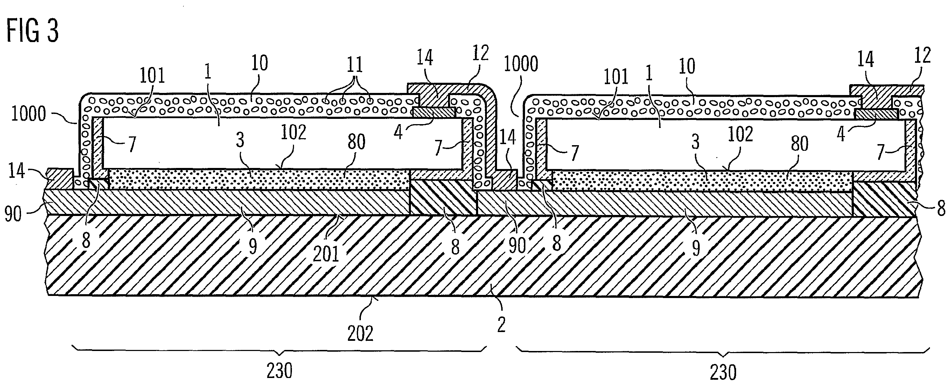

Bei dem dritten Ausführungsbeispiel gemäß der Figur 3 weisen die Halbleiterschichtstapel 1 ebenfalls je einen ersten Kontaktbereich 4 auf, der wie oben beschrieben auf der strahlungsemittierenden Vorderseite 101 des Halbleiterschichtstapels 1 angeordnet ist.

Im Gegensatz zu dem Ausführungsbeispiel der Figur 2 ist jedoch bei diesem Ausführungsbeispiel zwischen der ersten Hauptfläche 201 des Trägerkörpers 2 und dem Halbleiterschichtstapel 1 eine elektrisch leitende Schicht 9 eines elektrischen Anschlussleiters angeordnet, die beispielsweise auf dem Trägerkörper 2 abgeschieden ist. Die elektrisch leitende Schicht 9 umfasst beispielsweise ein Metall und ist zu voneinander elektrisch isolierten Teilbereichen wie Leiterbahnen strukturiert, mittels derer die Halbleiterschichtstapel an ihrer Rückseite 102 elektrisch kontaktiert sind.

Die elektrisch leitende Schicht 9 weist vorzugsweise Au und/oder Ag auf. Besonders bevorzugt weist die elektrisch leitende Schicht 9 eine Mehrschichtstruktur auf. Beispielsweise weist sie eine erste, dem Trägerkörper 2 benachbarte Schicht auf, die Cu aufweist oder daraus besteht, eine zweite Schicht, die in Richtung von dem Trägerkörper 2 weg auf die erste Schicht folgt und vorzugsweise Ni aufweist oder daraus besteht, sowie nachfolgend eine dritte, von dem Trägerkörper 2 abgewandte Schicht, die Au und/oder Ag aufweist oder daraus besteht. Die erste und/oder die zweite Schicht können durch eine Schicht ersetzt sein, die W auf weist oder daraus besteht. Die erste Schicht ist bei einer Weiterbildung galvanisch verstärkt. Die zweite Schicht stellt beispielsweise eine Migrationssperre dar. Die dritte Schicht dient zum Beispiel als Schutz- und/oder Kontaktschicht.

Der Barriererahmen 8 ist, vorliegend in jedem Montagebereich 230, stellenweise auf der elektrisch leitfähigen Schicht 9 aufgebracht und an anderen Stellen auf einem Bereich des Trägerkörpers 2 angeordnet, der von der elektrisch leitfähigen Schicht 9 freigelassen ist.

Wie auch beim vorhergehenden Ausführungsbeispiel sind die Befestigungsschichten 3 in Draufsicht auf die erste Hauptfläche 201 in Öffnungen 80 der Barriererahmen 8 angeordnet. Jede Befestigungsschicht 3 ist also auch bei diesem Ausführungsbeispiel von einem Barriererahmen 8 in Draufsicht auf die erste Hauptfläche 201 des Trägerkörpers 2 vollständig umschlossen.

Im Unterschied zum vorhergehenden Ausführungsbeispiel ist die Befestigungsschicht 3 jedoch auf der elektrisch leitfähigen Schicht 9 angeordnet und stellt einen elektrischen Kontakt zwischen letzterer und dem Halbleiterschichtstapel 1 her.

Zudem benetzt beispielsweise eine Befestigungsschicht 3, die ein Lötmetall umfasst, die elektrisch leitende und insbesondere metallische Schicht 9 besonders gut. Dies bewirkt eine verbesserte Haftung zwischen der Befestigungsschicht 3 und dem Trägerkörper 2, sodass eine besonders stabile mechanische Befestigung des Halbleiterschichtstapels 1 mit dem Trägerkörper 2 erzielt wird.

Eine elektrisch isolierende Deckschicht 10 bedeckt die Vorderseiten 101 der Halbleiterschichtstapel 1 und ist vorliegend über deren Flanken 103 auf die elektrisch leitfähige Schicht 9 auf die Barriereschicht 8 und/oder auf die erste Hauptfläche 201 des Trägerkörpers 2 gezogen.

Die elektrisch isolierende Schicht 10 ist für die von den Halbleiterschichtstapeln 1 im Betrieb emittierte elektromagnetische Strahlung vorzugsweise praktisch vollständig durchlässig. Alternativ kann sie ein Lumineszenzkonversionsmaterial 11 enthalten, beispielsweise einen mit Cer dotierten Yttrium-Aluminium-Granat-Leuchtstoff (YAG:Ce). Diese Ausführungsform der Deckschicht 10 ist beispielhaft im linken Bereich der Figur 3 gezeigt.

Das Lumineszenzkonversionsmaterial absorbiert zumindest einen Teil der von dem Halbleiterschichtstapel 1 emittierten elektromagnetischen Strahlung und emittiert, durch diese Absorption angeregt, selbst Fluoreszenz- oder Phosphoreszenzstrahlung, die vorzugsweise eine längere Wellenlänge aufweist als die absorbierte Primärstrahlung.

Die Deckschicht 10 weist Öffnungen 14 auf. Im Bereich der Öffnungen 14 bedeckt die Deckschicht 10 die elektrischen Kontaktbereiche 4 beziehungsweise die elektrisch leitende Schicht 9 nicht. Beispielsweise wird die Deckschicht 10 als geschlossene Fläche, anders ausgedrückt als einfach zusammenhängendes Gebiet, auf die Halbleiterschichtstapel 1 und den Trägerkörper 2 aufgebracht und anschließend im Bereich der Öffnungen 14, zum Beispiel mittels Laserablation, wieder entfernt.

Von der Deckschicht 10 freigelassene Stellen 90 der elektrisch leitenden Schicht 9 stellen elektrische Anschlussbereiche 90 dar, die zur elektrischen Kontaktierung der Halbleiterschichtstapel 1 von ihrer Rückseite vorgesehen sind.

Zumindest einige der elektrischen Anschlussbereiche 90 sind im Bereich von Aussparungen 1000 der Halbleiterschichtstapel 1 angeordnet. Im Bereich der Aussparungen 1000 ist der Abstand zwischen zwei benachbarten Halbleiterschichtstapeln 1 vergrößert, so dass mit Vorteil eine ausreichende Fläche für eine zuverlässige elektrische Kontaktierung zur Verfügung steht. In dem von der Aussparung nicht betroffenen Bereich der Flanken 103 haben die benachbarten Halbleiterschichtstapel 1 jedoch vorteilhafterweise den geringen Abstand D, der beispielsweise etwa 50 µm beträgt. Die Aussparung 1000 beeinträchtigt die Homogenität der Leuchtdichteverteilung der Leuchtdiodenanordnung daher vorteilhafterweise nicht oder nur geringfügig.

Auf der elektrisch isolierenden Deckschicht 10 ist eine elektrische Kontaktschicht mit einer Mehrzahl von elektrisch gegeneinander isolierten Leiterbahnen 12 angeordnet. Eine Leiterbahn 12 erstreckt sich bei dem Ausführungsbeispiel der Figur 3 von dem ersten Kontaktbereich 4 des ersten Halbleiterschichtstapels 1 zu dem elektrischen Anschlussbereich 90, mit dem der benachbarte, zweite Halbleiterschichtstapel 1 an seiner Rückseite 102 elektrisch kontaktiert wird. So wird eine Reihenschaltung zweier benachbarter Halbleiterschichtstapel 1 realisiert.

Die Leiterbahnen 12 werden beispielsweise mittels eines Verdampfungs- oder Sputter-Prozesses mit einem elektrisch leitfähigen Material, das insbesondere ein Metall oder ein transparentes leitfähiges Oxid (TCO, transparent conducting oxide) enthält, hergestellt. Das Verdampfen beziehungsweise Sputtern erfolgt beispielsweise durch eine Maske hindurch. Die Maske kann eine Schattenmaske sein oder mittels eines Photolithographie-Schritts auf der elektrisch isolierenden Deckschicht 10 hergestellt werden.

Alternativ können die Leiterbahnen 12 auch mittels eines Druckverfahrens, etwa eines Tintenstrahl-, Sieb- oder Tampon-Druckverfahrens mittels einer elektrisch leitfähigen Paste oder Flüssigkeit hergestellt werden. Die elektrisch leitfähige Paste oder Flüssigkeit enthält insbesondere elektrisch leitende Partikel, deren Partikelgröße beispielsweise kleiner oder gleich 10 µm, bevorzugt kleiner oder gleich 5 µm, besonders bevorzugt kleiner oder gleich 2 µm ist.

Die Leiterbahn 12 hat eine wesentlich geringere Ausdehnung senkrecht zu der ersten Hauptfläche 201 des Trägerkörpers 2 als der, insbesondere gebogene, Bond-Draht 6 gemäß dem Ausführungsbeispiel der Figur 2. Die Leuchtdiodenanordnung bei dem vorliegenden Ausführungsbeispiel gemäß der Figur 3 ist daher mit Vorteil besonders flach, oder anders ausgedrückt, sie hat eine besonders geringe Bauhöhe.

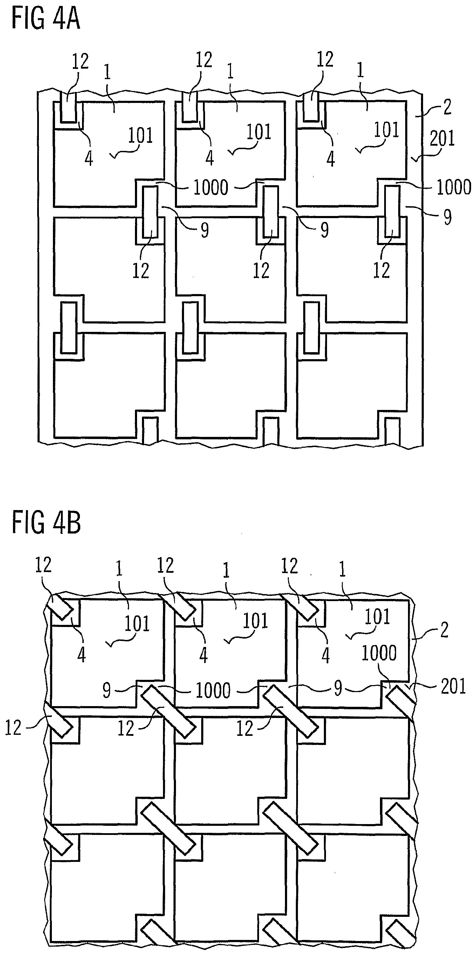

Bei diesem, wie auch bei den vorangehenden Ausführungsbeispielen, sind die Halbleiterschichtstapel 1 in Draufsicht auf die erste Hauptfläche 201 des Trägerkörpers 2 in einem Rechteckraster angeordnet. Ein Ausschnitt der Leuchtdiodenanordnung ist in einer schematischen Draufsicht auf die erste Hauptfläche 201 des Trägerkörpers 2 in der Figur 4A dargestellt. Die Leuchtdiodenanordnung gemäß Figur 4A umfasst neun Halbleiterschichtstapel 1, die in drei Reihen und drei Spalten angeordnet sind.

Jeder der Halbleiterschichtstapel 1 hat in Draufsicht auf seine Vorderseite 101 im Wesentlichen eine rechteckige, vorliegend eine quadratische, Form und weist eine Aussparung 1000 auf, die an einer Ecke des Halbleiterschichtstapels 1 angeordnet ist. Weiterhin weist jeder Halbleiterschichtstapel 1 einen elektrischen Kontaktbereich 4 auf, der an der Ecke angeordnet ist, die der Aussparung 1000 diagonal gegenüber liegt.

Bei diesem Ausführungsbeispiel sind die in Reihen angeordneten Halbleiterschichtstapel 1 in gleicher Ausrichtung nebeneinander auf dem Trägerkörper 2 befestigt. Halbleiterschichtstapel 1, die einander in den Spalten, die zu den Reihen senkrecht stehen, benachbart sind, sind jeweils um 90 Grad gegeneinander verdreht, so dass die Aussparung 1000 eines Halbleiterschichtstapels 1 dem elektrischen Kontaktbereich 4 des in der gleichen Spalte benachbarten Halbleiterschichtstapels 1 benachbart ist. Anders ausgedrückt sind in den Spalten jeweils die Aussparung 1000 eines Halbleiterschichtstapels 1 und der Kontaktbereich 4 eines in der Spalte benachbarten Halbleiterschichtstapels 1 einander zugewandt. Die Aussparung 1000 ist mit dem benachbarten Kontaktbereich 4 mit einer der elektrischen Leiterbahnen 12, die vorliegend in Richtung der Spalten verlaufen, elektrisch leitend verbunden. Die in Spalten angeordneten Halbleiterschichtstapel 1 sind also in Reihe geschaltet.

Die elektrischen Kontaktbereiche 4 beziehungsweise die elektrischen Anschlussbereiche 90 Halbleiterschichtstapel 1, die in der ersten beziehungsweise in der letzten Reihe angeordnet sind, sind mittels Leiterbahnen 12 mit einer TreiberSchaltung (nicht gezeigt) verbunden, die vorliegend ebenfalls auf dem gemeinsamen Trägerkörper 2 angeordnet und zur Ansteuerung der Halbleiterschichtstapel 1 vorgesehen ist.

Bei einer Variante dieser Ausführungsform sind nicht nur die in Reihen angeordneten Halbleiterschichtstapel 1 mit der gleichen Ausrichtung auf dem Trägerkörper 2 befestigt, sondern auch die in Spalten benachbarten Halbleiterschichtstapel 1. Diese Variante der Leuchtdiodenanordnung ist in der Figur 4B dargestellt. Die Leuchtdiodenanordnung umfasst bei diesem Ausführungsbeispiel beispielsweise Halbleiterschichtstapel in einem Rechteckraster mit mehr als drei Reihen und mehr als drei Spalten.

Bei der Variante der Figur 4B sind beispielsweise zwei Halbleiterschichtstapel 1 in Reihe geschaltet, indem ein Bond-Draht 6 oder eine elektrische Leiterbahn 12 von der Aussparung 1000 eines ersten Halbleiterschichtstapels 1 zu dem ersten Kontaktbereich 4 eines in Richtung einer Diagonale des Rechteckrasters benachbarten Halbleiterschichtstapels 1 gezogen ist. Beispielsweise verläuft die elektrische Leiterbahn 12 entlang dieser Diagonale des Rechteckrasters.

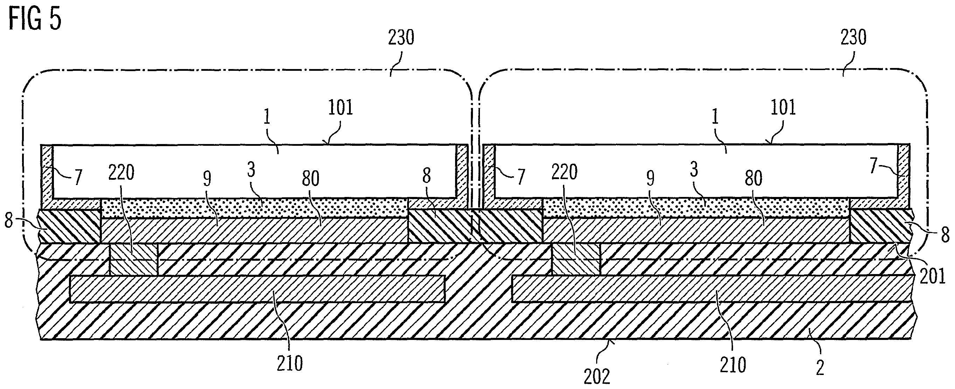

Wird für die Leuchtdiodenanordnung, wie in der Abwandlung gemäß der Figur 5, ein Trägerkörper 2 verwendet, der eine Mehrschichtstruktur aufweist, ist eine besonders flexible Verschaltung der einzelnen Halbleiterschichtstapel 1 möglich.

Der Trägerkörper 2 bei der Abwandlung gemäß der Figur 5 weist einen elektrischen Anschlussleiter zur elektrischen Kontaktierung der Halbleiterschichtstapel 1 auf, der eine strukturierte, elektrisch leitfähige Schicht 210 umfasst, die zwischen der ersten Hauptfläche 201 und der zweiten Hauptfläche 202, insbesondere also im Inneren des Trägerkörpers 2 verläuft. Der elektrische Anschlussleiter umfasst weiterhin Durchkontaktierungen 220, die an einigen Stellen von der elektrisch leitfähigen Schicht 210 zur ersten Hauptfläche 201 des Trägerkörpers 2 verlaufen. Beispielsweise weist mindestens ein Montagebereich 230 des Trägerkörpers 2 eine solche Durchkontaktierung 220 auf. Vorzugsweise weist eine Mehrzahl von Montagebereichen 230, insbesondere jeder Montagebereich 230 je eine Durchkontaktierung 220 auf.

Eine weitere elektrisch leitfähige Schicht 9 des elektrischen Anschlussleiters ist in Öffnungen 80 der Barriererahmen 8 angeordnet. Die in den Öffnungen 80 angeordneten Teilbereiche der weiteren elektrisch leitenden Schicht 9 sind mittels der Barriererahmen voneinander elektrisch isoliert und jeweils mit einer Durchkontaktierung 220 elektrisch leitend verbunden. Beispielsweise handelt es sich bei dem Trägerkörper 2 um einen mehrlagigen Keramikträger. Der mehrlagige Keramikträger wird beispielsweise durch gemeinsame Sinterung einer Mehrzahl von Keramikschichten und zumindest der strukturierten elektrisch leitfähigen Schicht 210 hergestellt.

Bei dieser Abwandlung wird beispielsweise jeder Halbleiterschichtstapel 1 einzeln angesteuert. So wird mit Vorteil eine besonders genaue Einstellung der Leuchtdichte erzielt. Beispielsweise können Abweichungen der Helligkeit und/oder des Farbeindrucks verschiedener Halbleiterschichtstapel 1 mittels einer geeigneten elektrischen Ansteuerung wie einer gepulsten Stromversorgung, die dem Fachmann an sich bekannt ist und daher an dieser Stelle nicht genauer erläutert wird, ausgeglichen werden. Die Leuchtdiodenanordnung gemäß dieser Abwandlung erzeugt daher einen besonders homogener Farbeindruck und hat eine besonders homogene Leuchtdichte.

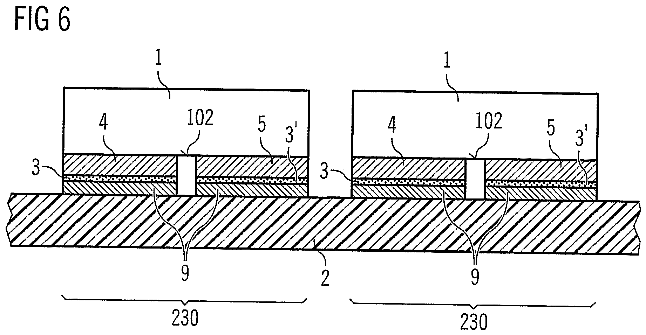

In Figur 6 ist eine Abwandlung einer Leuchtdiodenanordnung schematisch im Querschnitt dargestellt. Der erste Kontaktbereich 4 und der zweite Kontaktbereich 5 sind bei dieser Abwandlung zur Kontaktierung von der Rückseite 102 des Halbleiterschichtstapels 1 vorgesehen. Der erste und der zweite Kontaktbereich 4, 5 weisen dazu auf der Rückseite 102 jeweils eine Kontaktfläche auf, die mit je einer Leiterbahn 9 des Trägerkörpers 2 elektrisch kontaktiert und mechanisch befestigt ist.

Analog zum zweiten Kontaktbereich 5 des zweiten Ausführungsbeispiels ist beispielsweise der zweite Kontaktbereich 5 durch den Halbleiterschichtstapel 1 hindurch geführt, so dass er eine der Vorderseite 101 benachbarte Kontaktschicht kontaktiert (in Figur 6 nicht dargestellt). Ist beispielsweise die p-Seite des Halbleiterschichtstapels 1 dem Trägerkörper 2 zugewandt, so ist der erste Kontaktbereich 4 zur p-seitigen Kontaktierung und der zweite Kontaktbereich zur n-seitigen Kontaktierung vorgesehen. Alternativ kann auch die n-Seite des Halbleiterschichtstapels 1 dem Trägerkörper 2 zugewandt sein.

Die Befestigung des Halbleiterschichtstapels 1 erfolgt vorzugsweise wie bei den vorhergehenden Ausführungsbeispielen mittels Befestigungsschichten 3. Eine Befestigungsschicht 3 ist in diesem Fall zwischen der Kontaktfläche des ersten Kontaktbereichs 4 und der zugeordneten Leiterbahn 9 und eine weitere Befestigungsschicht 3' ist zwischen der Kontaktfläche des zweiten Kontaktbereichs 5 und der zugeordneten Leiterbahn 9 angeordnet. Die Befestigungsschicht 3 und die weitere Befestigungsschicht 3' sind disjunkt, so dass sie den Halbleiterschichtstapel 1 insbesondere nicht elektrisch kurzschließen.

Bei einer bevorzugten Ausführungsform begrenzt ein Barriererahmen 8 auf dem Trägerkörper 2 und/oder eine elektrisch isolierende Schicht 7 auf der Rückseite 102 des Halbleiterkörpers 1 die Befestigungsschicht 3 und die weitere Befestigungsschicht 3' (in Figur 6 nicht dargestellt). Besonders bevorzugt ist ein Teilbereich des Barriererahmens 8 zwischen den Leiterbahnen 9 angeordnet, die dem ersten und zweiten Kontaktbereich 4, 5 des Halbleiterschichtstapels 1 zugeordnet sind und/oder ein Teilbereich der elektrisch isolierenden Schicht 7 ist zwischen dem ersten und dem zweiten Kontaktbereich 4, 5 angeordnet. Insbesondere umschließt die elektrisch isolierende Schicht 7 die Kontaktflächen des ersten und zweiten Kontaktbereichs 4, 5 seitlich.

## Patentansprüche

1. Leuchtdiodenanordnung mit einer Mehrzahl von Halbleiterchips, die dazu vorgesehen sind, von ihrer Vorderseite (101) elektromagnetische Strahlung zu emittieren, und die mit ihrer der Vorderseite gegenüberliegenden Rückseite (102) auf einer ersten Hauptfläche (201) eines gemeinsamen Trägerkörpers (2) befestigt sind, wobei die Halbleiterchips aus je einem Halbleiterschichtstapel (1) bestehen und ohne Hilfsträger an dem gemeinsamen Trägerkörper befestigt sind,
wobei Aufwachssubstrate der Halbleiterschichtstapel (1) vollständig entfernt sind oder die Dicken der Aufwachssubstrate stark reduziert sind, und wobei der Abstand (H) zwischen der Vorderseite (101) eines jeden Halbleiterschichtstapels (1) und der ersten Hauptfläche (201) des Trägerkörpers (2) kleiner oder gleich 50 µm ist, wobei
- je zwei zueinander benachbarte Halbleiterschichtstapel (1) in Draufsicht auf die erste Hauptfläche (201) des Trägerkörpers (2) einen Abstand (D) von kleiner oder gleich 100 µm haben,
- die Halbleiterschichtstapel (1) in Reihe geschaltet sind, und wobei
- entweder die Halbleiterschichtstapel (1) je zwei elektrische Kontaktbereiche (4, 5) aufweisen, die zum elektrischen Anschließen des jeweiligen Halbleiterschichtstapels (1) auf seiner Vorderseite (101) angeordnet sind,
- oder die Halbleiterschichtstapel (1) je einen elektrischen Kontaktbereich (4) sowie eine Aussparung (1000) aufweisen, wobei der elektrische Kontaktbereich (4) zum elektrischen Anschließen des Halbleiterschichtstapels (1) an seiner Vorderseite (101) angeordnet ist und wobei der Trägerkörper (2) im Bereich der Aussparungen (1000) einen Anschlussbereich (90) aufweist, der mit der Rückseite (102) des Halbleiterschichtstapels (1) elektrisch leitend verbunden ist.

2. Leuchtdiodenanordnung nach Anspruch 1, bei dem die Halbleiterschichtstapel (1) eine Dicke von kleiner oder gleich 20 µm haben.

3. Leuchtdiodenanordnung nach einem der Ansprüche 1 bis 2, bei der mindestens zwei Halbleiterschichtstapel (1) in Draufsicht auf die erste Hauptfläche (201) des Trägerkörpers (2) einen Abstand (D) von kleiner oder gleich 50 µm haben.

4. Leuchtdiodenanordnung nach einem der vorhergehenden Ansprüche, bei der der Abstand (H) zwischen der Vorderseite (101) eines jeden Halbleiterschichtstapels (1) und der ersten Hauptfläche (201) des Trägerkörpers (2) kleiner oder gleich 20 µm ist.

5. Verfahren zum Herstellen einer Leuchtdiodenanordnung, bei dem ein Trägerkörper (2) mit einer Mehrzahl von Montagebereichen (230), die in Draufsicht auf eine erste Hauptfläche (201) des Trägerkörpers nebeneinander angeordnet sind, bereitgestellt wird und, zu gleichen Zeiten oder sequentiell, in jedem Montagebereich
- eine Befestigungsschicht (3) auf der ersten Hauptfläche des Trägerkörpers ausgebildet wird,
- ein Halbleiterchip, der dazu vorgesehen ist, von seiner Vorderseite (101) elektromagnetische Strahlung zu emittieren, so auf der Befestigungsschicht platziert wird, dass seine Vorderseite von der Befestigungsschicht abgewandt ist,
- der Halbleiterchip auf der Befestigungsschicht ausgerichtet wird und
- eine mechanisch stabile Verbindung zwischen dem Halbleiterchip und dem Trägerkörper mittels der Befestigungsschicht hergestellt wird, wobei der Halbleiterchip aus einem Halbleiterschichtstapel (1) besteht, wobei Aufwachssubstrate der Halbleiterschichtstapel (1) vollständig entfernt sind oder die Dicken der Aufwachssubstrate stark reduziert sind, wobei kein Hilfsträger zwischen dem Halbleiterschichtstapel und dem Trägerkörper angeordnet wird, und wobei der Abstand (H) zwischen der Vorderseite (101) des Halbleiterschichtstapels (1) und der ersten Hauptfläche (201) des Trägerkörpers (2) kleiner oder gleich 50 µm ist,
wobei
- je zwei zueinander benachbarte Halbleiterschichtstapel (1) in Draufsicht auf die erste Hauptfläche (201) des Trägerkörpers (2) in einem Abstand (D) von kleiner oder gleich 100 µm haben,
- die Halbleiterschichtstapel (1) in Reihe geschaltet werden, und wobei
- entweder die Halbleiterschichtstapel (1) je zwei elektrische Kontaktbereiche (4, 5) aufweisen, die zum elektrischen Anschließen des jeweiligen Halbleiterschichtstapels (1) auf seiner Vorderseite (101) angeordnet sind,
- oder die Halbleiterschichtstapel (1) je einen elektrischen Kontaktbereich (4) sowie eine Aussparung (1000) aufweisen, wobei der elektrische Kontaktbereich (4) zum elektrischen Anschließen des Halbleiterschichtstapels (1) an seiner Vorderseite (101) angeordnet ist und wobei der Trägerkörper (2) im Bereich der Aussparungen (1000) einen Anschlussbereich (90) aufweist, der mit der Rückseite (102) des Halbleiterschichtstapels (1) elektrisch leitend verbunden ist.

## Claims

1. A light emitting diode arrangement comprising a plurality of semiconducting chips, which are configured to emit electromagnetic radiation from their front side (101) and which are fixed with their rear side (102), lying opposite to the front side, to a first main surface (201) of a common carrier body (2), wherein the semiconductor chips each consist of a semiconductor layer stack (1) and are fixed to the common carrier body without auxiliary carriers,
wherein growth substrates of the semiconductor layer stacks (1) are completely removed or the thicknesses of the growth substrates are greatly reduced, and wherein the distance (H) between the front side (101) of each semiconductor layer stack (1) and the first main surface (201) of the carrier body (2) is less than or equal to 50 µm, wherein
- two adjacent semiconductor layer stacks (1) each have a distance (D) of less than or equal to 100 µm in plan view of the first main surface (201) of the carrier body (2),
- the semiconductor layer stacks (1) are connected in series, and wherein
- either the semiconductor layer stacks (1) each have two electrical contact regions (4, 5) which are arranged on its front side (101) for electrically connecting the respective semiconductor layer stack (1),
- or the semiconductor layer stacks (1) each have an electrical contact region (4) and a gap (1000), wherein the electrical contact region (4) is arranged on its front side (101) for electrically connecting the semiconductor layer stack (1), and wherein the carrier body (2) has a connection region (90) in the region of the gaps (1000) which is electrically conductively connected to the rear side (102) of the semiconductor layer stack (1).

2. The light emitting diode arrangement according to claim 1, in which the semiconductor layer stacks (1) have a thickness of less than or equal to 20 µm.

3. The light emitting diode arrangement according to one of claims 1 to 2, in which at least two semiconductor layer stacks (1) have a spacing (D) of less than or equal to 50 µm in plan view of the first major surface (201) of the carrier body (2).

4. The light emitting diode arrangement according to any of the preceding claims, in which the distance (H) between the front side (101) of each semiconductor layer stack (1) and the first main surface (201) of the substrate (2) is less than or equal to 20 µm.

5. A method for producing a light emitting diode arrangement, in which a carrier body (2) with a plurality of mounting regions (230), which are arranged next to one another in plan view of a first main surface (201) of the carrier body, is provided and, at the same times or sequentially, in each mounting region
- a fastening layer (3) is formed on the first main surface of the carrier body,
- a semiconductor chip intended to emit electromagnetic radiation from its front side (101) is placed on the fastening layer such that its front side is facing away from the fastening layer,
- the semiconductor chip is aligned on the fastening layer and
- a mechanically stable connection is established between the semiconductor chip and the carrier body by means of the fastening layer, wherein the semiconductor chip consists of a semiconductor layer stack (1), wherein growth substrates of the semiconductor layer stacks (1) are completely removed or the thicknesses of the growth substrates are greatly reduced, wherein no auxiliary carrier is disposed between the semiconductor layer stack and the carrier body, and wherein the distance (H) between the front side (101) of the semiconductor layer stack (1) and the first main surface (201) of the carrier body (2) is less than or equal to 50 µm,
wherein
- two adjacent semiconductor layer stacks (1) each have a distance (D) of less than or equal to 100 µm in plan view of the first main surface (201) of the carrier body (2),
- the semiconductor layer stacks (1) are connected in series, and wherein
- either the semiconductor layer stacks (1) each have two electrical contact regions (4, 5) which are arranged on its front side (101) for electrically connecting the respective semiconductor layer stack (1),
- or the semiconductor layer stacks (1) each have an electrical contact region (4) and a gap (1000), wherein the electrical contact region (4) is arranged on its front side (101) for electrically connecting the semiconductor layer stack (1), and wherein the carrier body (2) has a connection region (90) in the region of the gaps (1000) which is electrically conductively connected to the rear side (102) of the semiconductor layer stack (1).

## Revendications

1. Dispositif à diodes électroluminescentes comportant une pluralité de puces à semi-conducteurs qui sont prévues pour émettre un rayonnement électromagnétique par leur face avant (101), et qui sont fixées par leur face arrière (102) opposée à la face avant sur une première surface principale (201) d'un corps porteur commun (2), les puces à semi-conducteurs étant constituées respectivement d'un empilement de couches semi-conductrices (1) et fixées au corps porteur commun sans substrat auxiliaire,
les substrats de croissance des empilements de couches semi-conductrices (1) étant enlevés complètement ou les épaisseurs des substrats de croissance étant fortement réduites, et l'écart (H) entre la face avant (101) de chaque empilement de couches semi-conductrices (1) et la première surface principale (201) du corps porteur (2) étant inférieur ou égal à 50 µm, **caractérisé en ce que**
- respectivement deux empilements de couches semi-conductrices (1) mutuellement adjacents ont un écart (D) inférieur ou égal à 100 µm en vue de dessus de la première surface principale (201) du corps porteur (2),
- les empilements de couches semi-conductrices(1) sont montés en série, et **caractérisé en ce que**
- soit les empilements de couches semi-conductrices (1) présentent respectivement deux zones de contact électrique (4, 5) qui, pour le raccordement électrique de l'empilement de couches semi-conductrices (1) respectif, sont disposées sur sa face avant (101),
- soit les empilements de couches semi-conductrices (1) présentent respectivement une zone de contact électrique (4) ainsi qu'une cavité (1000), la zone de contact électrique (4) étant, pour le raccordement électrique de l'empilement de couches semi-conductrices (1), disposée sur sa face avant (101) et le corps porteur (2) présentant dans la zone des cavités (1000) une aire de raccordement (90) qui est reliée de manière électroconductrice à la face arrière (102) de l'empilement de couches semi-conductrices (1).

2. Dispositif à diodes électroluminescentes selon la revendication 1, **caractérisé en ce que** les empilements de couches semi-conductrices (1) ont une épaisseur inférieure ou égale à 20 µm.

3. Dispositif à diodes électroluminescentes selon l'une quelconque des revendications 1 à 2, **caractérisé en ce qu'**au moins deux empilements de couches semi-conductrices (1) ont un écart (D) inférieur ou égal à 50 µm en vue de dessus de la première surface principale (201) du corps porteur (2).

4. Dispositif à diodes électroluminescentes selon l'une quelconque des revendications précédentes, **caractérisé en ce que** l'écart (H) entre la face avant (101) de chaque empilement de couches semi-conductrices (1) et la première surface principale (201) du corps (2) est inférieur ou égal à 20 µm.

5. Procédé pour la fabrication d'un dispositif à diodes électroluminescentes, **caractérisé en ce qu'**un corps porteur (2) comportant une pluralité de zones de montage (230) qui sont disposées les unes à côté des autres en vue de dessus d'une première surface principale (201) du corps porteur est fourni et **en ce que**, parallèlement ou séquentiellement, dans chaque zone de montage
- une couche de fixation (3) est formée sur la première surface principale du corps porteur,
- une puce à semi-conducteurs qui est prévue pour émettre un rayonnement électromagnétique par sa face avant (101) est placée sur la couche de fixation de sorte que sa face avant est détournée de la couche de fixation,
- la puce à semi-conducteurs est orientée sur la couche de fixation et
- une liaison mécaniquement stable est établie entre la puce à semi-conducteurs et le corps porteur par l'intermédiaire de la couche de fixation, la puce à semi-conducteurs se composant d'un empilement de couches semi-conductrices (1), les substrats de croissance des empilements de couches semi-conductrices (1) étant enlevés complètement ou les épaisseurs des substrats de croissance étant fortement réduites, aucun substrat auxiliaire n'étant placé entre l'empilement de couches semi-conductrices et le corps porteur, et l'écart (H) entre la face avant (101) de l'empilement de couches semi-conductrices (1) et la première surface principale (201) du corps porteur (2) étant inférieur ou égal à 50 µm,
**caractérisé en ce que**
- respectivement deux empilements de couches semi-conductrices (1) mutuellement adjacents ont un écart (D) inférieur ou égal à 100 µm en vue de dessus de la première surface principale (201) du corps porteur (2),
- les empilements de couches semi-conductrices(1) sont montés en série, et **caractérisé en ce que**
- soit les empilements de couches semi-conductrices (1) présentent respectivement deux zones de contact électrique (4, 5) qui, pour le raccordement électrique de l'empilement de couches semi-conductrices (1) respectif, sont disposées sur sa face avant (101),
- soit les empilements de couches semi-conductrices (1) présentent respectivement une zone de contact électrique (4) ainsi qu'une cavité (1000), la zone de contact électrique (4) étant, pour le raccordement électrique de l'empilement de couches semi-conductrices (1), disposée sur sa face avant (101) et le corps porteur (2) présentant dans la zone des cavités (1000) une aire de raccordement (90) qui est reliée de manière électroconductrice à la face arrière (102) de l'empilement de couches semi-conductrices (1).
